(19) **Europäisches Patentamt / European Patent Office / Office européen des brevets**

(11) **EP 2 286 442 B1**

(12) **EUROPEAN PATENT SPECIFICATION**

(45) Date of publication and mention of the grant of the patent:
**27.07.2016 Bulletin 2016/30**

(21) Application number: **09746246.9**

(22) Date of filing: **12.05.2009**

(51) Int Cl.:
*H01L 49/02* (2006.01)    *H01L 27/08* (2006.01)

(86) International application number:
**PCT/IB2009/051953**

(87) International publication number:
**WO 2009/138951 (19.11.2009 Gazette 2009/47)**

(54) **METHOD OF FABRICATION OF LOW VALUE RESISTORS IN A SEMICONDUCTOR MATERIAL**

VERFAHREN ZUR HERSTELLUNG VON NIEDERWERTIGEN WIDERSTÄNDEN IN EINEM HALBLEITERMATERIAL

PROCÉDÉ DE FABRICATION DE RÉSISTANCES DE FAIBLE VALEUR DANS UN MATÉRIAU SEMI-CONDUCTEUR

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **13.05.2008 EP 08290443**

(43) Date of publication of application:
**23.02.2011 Bulletin 2011/08**

(73) Proprietor: **IPDIA**
**14000 Caen (FR)**

(72) Inventors:
• **JACQUELINE, Sebastien**
  **NL-5656 AE Eindhoven (NL)**

• **BARDY, Serge**
  **NL-5656 AE Eindhoven (NL)**
• **CHEVRIE, David**
  **NL-5656 AE Eindhoven (NL)**
• **LECORNEC, Francois**
  **NL-5656 AE Eindhoven (NL)**

(74) Representative: **Cabinet Plasseraud**
**66, rue de la Chaussée d'Antin**
**75440 Paris Cedex 09 (FR)**

(56) References cited:
**EP-A- 0 621 631       EP-A- 1 324 375**
**US-A1- 2005 230 777   US-A1- 2007 040 236**

## Description

### FIELD OF THE INVENTION

The present application proposes a low value resistor suitable for manufacture in a semiconductor substrate and a method of fabricating a low value resistor. The resistor is formed from a 3D pattern etched into a substrate. The pattern is etched to a depth of at least 5 microns and filled with a resistive material. The resistor also comprises electrical contacts attached to the resistor and the substrate. The resistor comprises a number of optional features.

### BACKGROUND OF THE INVENTION

Every integrated circuit uses resistive components. The processes of fabrication of such components have hardly changed since the event of the first integrated circuits. The integrated resistors are built in a conductive layer with a controlled resistivity, and form a junction with the underlying semiconductor material. Such conductive layer is realized either by ionic implant or by deposition (solid or gas) of chemical species, followed by an annealing step that activates the doping elements.

Resistive layers are often characterized by the resistance of an element with a square-shape geometry (sheet resistance in $\Omega/\square$). This sheet resistance $R_\square$ is proportional to the resistivity $\rho$ of the layer and inversely proportional to its thickness d.

$$R_\square = \rho/d$$

The resistance of a rectangular element is calculated by multiplying the value of $R_\square$, technological constant of the layer, by the number of squares of the rectangular element.

The conventional techniques do not allow layers with a very low $R_\square$, for instance below 1 $\Omega/\square$, due to:

- limitations caused by equipments used for the fabrication of the integrated circuits: such as doses and energy for the implant, etc., for parameters influencing the resistivity;
- physical and practical limitations: such as solubility, segregation of the doping elements, time and diffusion temperature, etc., for parameters influencing the thickness of the layer.

It is noted resistivity is a widely used parameter for specification and characterization of silicon wafers for use in fabricating semiconductor devices and integrated circuits. Many types of instrumentation used for making resistivity measurements including the non-contact eddy-current instruments used for measurements made in accordance with SEMI MF673, DIN 50445, or DIN 50447 require calibration because they are relative measurements. Although measurements made with in-line four-point probes in accordance with SEMI MF84 or DIN 50441 are, in principle, absolute, control charts should be maintained for four-point probes because one cannot always be sure that the electrical resistivity of the test specimen is sufficiently homogeneous for the theoretical model of the method to apply, that the electrical thickness of the wafer is exactly equal to its measured mechanical thickness, or that the stability of the instrument is adequate.

Various low value resistors are known from the prior art.

US2005/093097 A1 discloses a method of forming a semiconductor structure in a semiconductor wafer includes the steps of forming an epitaxial layer on at least a portion of a semiconductor substrate of a first conductivity type and forming at least one trench through the epitaxial layer to at least partially expose the substrate. The method further includes doping at least one or more sidewalls of the at least one trench with an impurity of a known concentration level. The at least one trench is then substantially filled with a filler material. In this manner, a low-resistance electrical path is formed between an upper surface of the epitaxial layer and the substrate.

US2005/093097 A1 discloses a method of forming a low resistance electrical path in a semiconductor substrate. The method involves etching holes in a silicon substrate to a depth of 10 microns or more. The pitch between adjacent holes is of the order of 1 or 2 microns. The sidewalls of the holes are then doped and subsequently filled with polysilicon. Other filling materials include CVD tungsten, silicide or doped polysilicon. Electrical contacts to the device are also formed.

The process comprises the steps of formation of openings, formation of deep trenches, and trench fill process. However, the purpose thereof is to create a low-resistance path, i.e. a vertical electrical contact, between an upper surface and the substrate (below), which is not a low value resistor, wherein further both electrodes are provided on the upper silicon surface. Furthermore, most of the depth of hole subsequently forming the contact is created in the epitaxial layer, and not in the substrate. The hole itself is not covered with an insulating layer, but filled with a material, which must be conducting by the nature of it.

WO2007/066037 A1 discloses a resistive element comprising two vertical resistive parts placed in two holes formed in the upper part of a substrate and a horizontal resistive part formed in a buried cavity connecting the bottoms of the holes.

The WO2007 patent application is dedicated to the realization of 3D resistors with the association in series of a limited number of two vertical holes and a horizontal resistive part (inside a substrate). However, it relates to the creation of a resistor with low footprint, that is having a small silicon surface. Such a resistor is not the same nor similar to a resistor with a low sheet resistance. Further, the trenches are filled with two insulating layers, having one conducting layer in between.

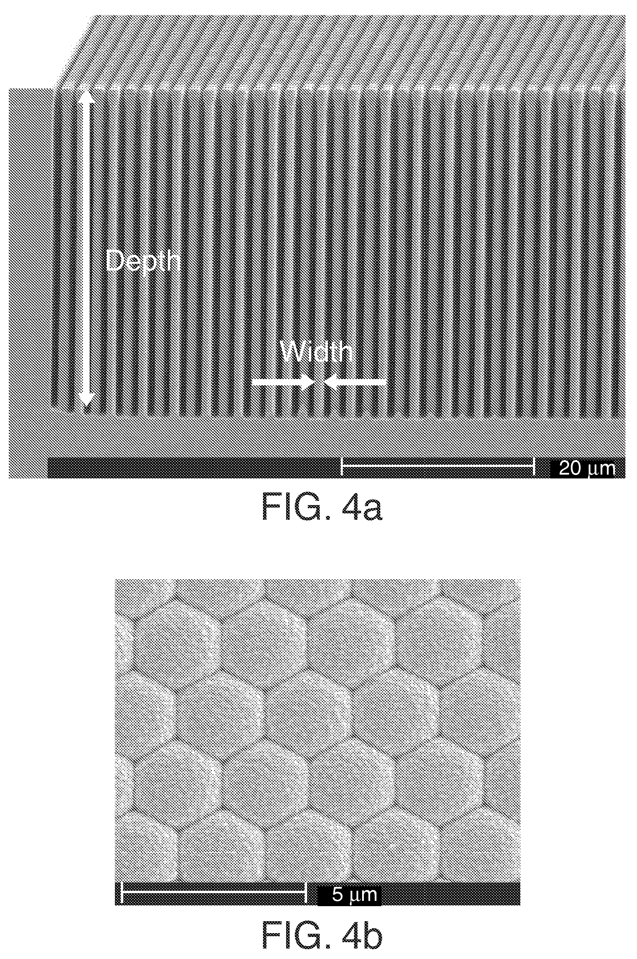

Thus, the method proposed in WO2007/066037 consists of the association in series of a limited number of two vertical holes and a buried horizontal cavity. The resistive material is patterned into small bands (4 $\mu$m, see e.g. fig. 4) to allow the integration of resistors with low footprint. Clearly, this is a way to maximize the length of the resistor serpentines, without increasing the surface footprint. Basically, this is 3D resistor integration (high resistor value in small silicon surface). As such it is not possible to obtain a varity of resistivities, starting from one material, by filling a 3D pattern, and by using the amplified height of the bulk structure.

US2005/263850 A1 discloses an on-chip, ultra-compact, and programmable semiconductor resistor device and device structure and a method of fabrication. Each semiconductor resistor device structure is formed of one or more conductively connected buried trench type resistor elements exhibiting a precise resistor value. At least two semiconductor resistor device structures may be connected in series or in parallel configuration through the intermediary of one or more fuse devices that may be blown to achieve a desired total resistance value.

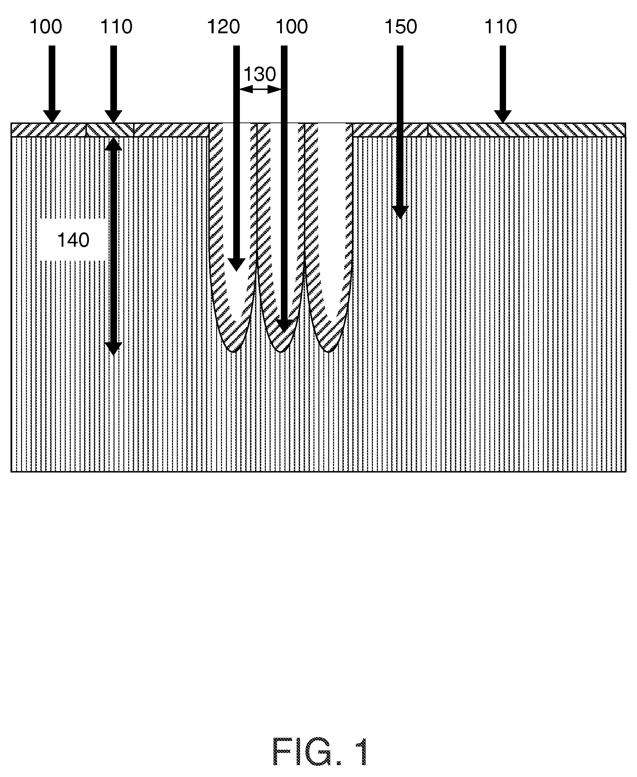

This patent application presents a semiconductor resistor devices that can be connected in series or in parallel. As shown in figure 1 of this application, the adjacent trenches are linked by the bottom, with bands 25 inside the substrate. This concept is very close to the one disclosed in WO2007/066037 A1.

Thus WO2007/066037 A1 and US2005/263850 A1 disclose resistors formed in a semiconductor substrate. WO2007/066037 A1 discloses etching a 3D pattern comprising two vertical trenches connected by a horizontal cavity. The trenches are etched to a depth of 50 microns and have a pitch of 2 microns. After the 3D pattern is formed the sidewalls of the trenches and cavity are provided with an insulating layer. A resistive layer is then formed on the insulating layer and another insulating layer is formed on the resistive layer. The trenches are subsequently filled with doped or undoped polysilicon. Electrical connections to the resistor and substrate are then formed. US2005/263850 A1 discloses a similar method where trenches are etched in a silicon substrate up to a depth of 7 microns with a pitch of between 0.1 and 10 microns. The bottom surface of the trenches are then doped to form bottom buried plate contacts and the sides of the trenches are provided with a dielectric layer. Subsequently, the trenches are filled with polysilicon. The method proposed in US2005/263850 consists of buried trenches with a depth ranging from 1.0 $\mu$m to 7.0$\mu$m, for on-chip precision resistor. The resistor includes a series of trenches 52a, 52b... 52n that are only connected by the top surface resistive connector 60. The resistance is then proportional to the trench depth (see present equation 1 and equation 2). Thus this document relates to somewhat shallow resistors, having a relatively high resistivity. In this document each trench is separated by a dielectric region 56, and between adjacent trenches the electrical connection is formed by a top surface connector 60.

JP02148760 A discloses a semiconductor device and method of manufacture thereof. Its purpose is to obtain a low resistance by opening a trench groove on the surface of a semiconductor substrate, forming an insulating film along the sidewall of the groove when the groove is filled with electric conductor, laminating polycrystalline silicon or amorphous silicon thereon, and filling a cavity formed thereby with metal. Thereto, a trench groove acting as an isolating groove is opened in the surface layer of a semiconductor substrate. Then the groove is filled with an electric conductor. An insulating film is formed on the bottom and the sidewall of the groove, and the surface of the substrate, and polycrystalline or amorphous silicon is deposited on the whole surface including it by a vapor growing method. Here, the width of the groove is, for example, 0.5 $\mu$m, the depth is 4.0 $\mu$m, the thickness of the film is 10 nm, and the thickness of the silicon 4 is 100nm. Thereafter, etching gas is blown perpendicularly to the substrate, the polycrystalline silicon is anisotropically etched to form a cavity, and the polycrystalline silicon on the substrate is all removed. Then, W is filled only in the cavity.

JP02148760 A discloses forming a low resistance trench resistor in a silicon substrate to a depth of 4 microns. It does not appear to anticipate the draft claims as the trench is too shallow and it does not appear to disclose a 3D pattern having a pitch. Further the dimensions are different and it does not appear to disclose a 3D pattern having a pitch.

In view of the above there still is a need of improved resistors, specifically 3D resistors. These should not have the above drawbacks and limitations. Further, these resistors should preferably be easily integrated into existing processes, and be relatively cheap to process.

SUMMARY OF THE INVENTION

The invention relates to a semiconductor device and a method according to claims 1 and 8.

Advantages of the present invention, as well as embodiments, are described below.

DETAILED DESCRIPTION OF THE INVENTION

In a first aspect the present invention relates to a semiconductor device comprising a substrate (150), preferably silicon, at least one 3D low value resistor having a resistance of smaller than 1 $\Omega$/ , wherein the resistor is present within the substrate by a 3D pattern consisting out of a multiplicity of repeating structures having edges, having a depth (140) in the substrate of more than 5 $\mu$m, and having a pitch p (130), wherein the edges (100) of the 3D pattern are optionally N- or P-type doped, having an insulating material (260) on the edges of one or more materials selected from the group consisting of oxide, silicon nitride, undoped polysilicon, or other oxides such as $Ta_2O_5$, $HfO_2$, $Al_2O_3$, wherein the 3D pattern is further filled with a layer (270) having a thickness d of one or more materials selected from the group consisting of doped polysilicon, and conducting material such as metal or alloy, such as TiN, TiW, TiCu, which layer edges are delimited by photolithography, further comprising electrically conducting contacts (390) attached to the resistor comprising polysilicon, and electrically conducting contacts (380) attached to the substrate or optionally being doped substrate.

Examples of 3D patterns are given in the figures. Typically a pattern consists of repeating structures, such as holes, or trenches, or combinations of such structures. There is a multiplicity of such structures present. For example, tens, or hundreds, or thousands of e.g. holes may be present in a first direction and/or in a second direction, said first and second direction being in the plane of the substrate. Each sub-structure, i.e. such as hole, has edges. The sub-structure has a certain depth. It is noted that the depth may be varied over the sub-structures, if required. The depth is indicated in e.g. figure 1. The pattern is further characterized in that the distance between the centers of the sub-structures, or a relatively large sub-set of sub-structures, is constant, said distance being defined as the pitch $p$ (see also fig. 1). The edge of the sub-structure is optionally N- or P-type doped, with a desired doping concentration, depending on the requirements. The edge is further covered, from shaft to center, by an insulating material having a thickness d, and a conducting material. As terminals contacts are attached to the polysilicon and to the substrate, respectively.

In a preferred embodiment the present device has a resistivity of the resistor which is smaller than 1 $\Omega/$ , preferably smaller than 0.5 $\Omega/$ , more preferably smaller than 0.3 $\Omega/$ , even more preferably smaller than 0.1 $\Omega/$ , most preferably smaller than 0.05 $\Omega/$ , such as smaller than 0.001 $\Omega/$ , wherein the pitch $p$ is preferably from 0.2 $\mu$m to less than 5 $\mu$m, preferably from 0.4 $\mu$m to 3 $\mu$m, more preferably from 0.6 $\mu$m to 2 $\mu$m, such as 1 $\mu$m.

In a preferred embodiment the present device has a thickness d of the layer (270) which is larger than $p/2$, preferably larger than 0.75 $p$, more preferably larger than $p$, such as 2 $p$.

The polysilicon layer has a thickness called "d" (1 $\mu$m typically). It is deposited inside structures of height "h" (> 5 $\mu$m) and small pitch "p". This structure "amplifies" the apparent thickness of the polysilicon, the apparent polysilicon layer now being close to "h". This effect provides a low sheet resistance: the thickness is much deeper than usual junctions. The sheet resistance is divided.

In a preferred embodiment the present device has a depth of the 3D pattern which is larger than 5 $\mu$m, preferably larger than 7 $\mu$m, more preferably larger than 10 $\mu$m, even more preferably larger than 20 $\mu$m, such as larger than 50 $\mu$m. The larger the depth, the lower the resistance.

In a preferred embodiment the present device has structures in the 3D pattern which are chosen from the group comprising holes, trenches, pillars, tripods, walls, columns, cavities, and combinations thereof. By varying the structures, or combinations thereof, specifications of the resistor may be tuned.

In a preferred embodiment the present device has polysilicon which is P- or N-type doped, and the substrate is N- or P-type doped, respectively. By doping, the specifications of the resistor may be tuned.

In a preferred embodiment the present device has a doped polysilicon resistor which is connected in parallel to the doped silicon resistor.

Sub-structures of the present invention may have a circular diameter, or a rectangular, such as square, or a hexagonal, or an octagonal, or a multigonal diameter, and combinations thereof. A hexagonal diameter is preferred.

The insulating material (260) thickness may vary from 0.01 $\mu$m up to 2 $\mu$m

The filling material (270) thickness may vary from 0.1 $\mu$m up to 10 $\mu$m

An advantage of the present invention is that the present low value resistor can be obtained without an extra processing step, i.e. substantially without additional costs.

A further advantage is that the present resistor offers a new range of low R□ values, on the same die. For instance the R□ on 2D-structure (Ohm/□) is 5 for doped silicon (HL) and 10 for doped polysilicon (PS), respectively, and 0.5 and 1 for a doped silicon and doped polysilicon 3D structure, respectively. So the present resistor offers a resistor having a resistivity of at least one order lower than prior art resistors.

A major advantage is the option now available to provide at least 2 different R□ for a single material, with the optional addition of an underneath 3D structure. By sizing the underneath 3D structure, the present application can offer a range of Rsq for one deposited resistive material.

The proposed method is a "native" technology building-block that can be integrated to most 3D passive processes. In the Pics processes, this method offers "free" features, since the 3D structures are already available on the substrate (no additional layer nor mask). This is also applicable for future processes, such as Pics with copper, for which the metallic R□ can drop down to 0.001 ohm/□. Then, the range of R□ would be even larger.

Evenmore, the reliability of aluminum resistors is an issue, due to electromigration: to overcome this problem, the design of the resistor must be wide enough to avoid failure. In the present case, any electromigration issue is observed yet.

Most products in Pics1 and Pics2 technology integrate polysilicon resistors, which demonstrate that reproducibility is not an issue. The present invention combining those resistors with 3D structure will not dramatically degrade these performances.

Due to very low R□ of aluminum (0.01 - 0.03 ohm/□), the footprint of metallic resistors is at least 10 times bigger than for 3D resistors. Therefore, the present resistor is a new way to integrate resistors.

In a second aspect the present invention relates to a method for manufacturing a semiconductor device according to the invention, comprising the steps of:

 a) providing a substrate,
 b) optionally forming a mask of an insulating material having a thickness of 0.1 $\mu$m to 10 $\mu$m that does not oxidizes in the presence of oxygen, and forming a pattern on said mask,
 c) etching a 3D pattern with a depth (140) of more than 5 $\mu$m, preferably by plasma etching or wet etching, for instance using a gas such as $SF_6/O_2$, $NF_3$, or a liquid comprising KOH, HF, or TMAH, wherein the pattern has a depth of 5 $\mu$m to 50 $\mu$m and has a width from 0.5 $\mu$m to 5 $\mu$m,
 d) optionally doping the substrate and 3D pattern with a concentration of $10^{15}$ - $10^{20}$ at/cm$^3$, wherein the doping is delimited by the mask, optionally in the presence of oxygen,
 e) optionally dissolving the oxide layer in an adapted solution, such as by buffered oxide etch or HF,
 f) optionally depositing or growing one or several layers of an insulating material all over the surface of the substrate, which one or several layers have a thickness of 0.01 $\mu$m to 2 $\mu$m,
 g) filling the 3D pattern with a layer (270) having a thickness $d$ of one or more materials selected from the group consisting of doped polysilicon, and conducting material such as metal or alloy, which layer edges are delimited by photolithography, thereby forming a doped silicon resistor and a polysilicon resistor, and
 h) realizing electrodes in order to electrically contact the resistors.

The proposed method explains how to realize two resistive layers with very small sheet resistances ($\leq$ 1 $\Omega/\square$ ) by using a technique, described below, which "amplifies" the thickness of the two layers. Therein a low sheet resistance is due to the association in parallel of the elements of the network, to amplifie the deposited thicknesses.

With prior art resistors the formula given for resistance is

$$R_{trench} = \rho * (2*h+w)/(t*L),$$

wherein $R_{trench}$ is the resistance of a trench, $\rho$ is the resistivity constant of a material used therein, h is the height of the trench, w the width thereof, t is the conductive film thickness and L is the 3D structure width (e.g. wing mask width). This means that the resistance of a prior art resistor is *multiplied* by the height h of the trenches. On the contrary, in the present case, the resistance is divided by the height of the trenches, that is divided by the junction depth.

Another difference with prior art resistors is the dimensions of the present resistors. For the prior art resistor this is limited to up to 10$\mu$m for a CMOS process, whereas for the present invention it is from 5$\mu$m to 50$\mu$m for passive integration processes. A further difference for the present resistor is that a doped Polysilicon resistor and a doped silicon resistor are connected in parallel, resulting in even smaller sheet resistances.

This method provides layers with standard resistivities but with thicknesses that are much deeper than usual junction. If the new junction depth is now D, the sheet resistance of this new layer is decreased within the f=D/d ratio of the thicknesses.

$$RD = p/(f*d) \ [2]$$

The method consists in etching in one single stage the area for the future resistive elements, made of a series of 3D patterns (holes, trenches, pillars, cavities, etc.) with a large height (height h > 5 $\mu$m) and a small spacing (pitch p).

After doping and annealing, the doping elements have diffused inside the substrate from the bottom of the 3D patterns; and create an electrical junction with the substrate, at a distance increased by the height of the 3D patterns. Then, one gets a first layer, with an homogeneous resistivity and a height larger than the depth of the 3D patterns.

An insulating dielectric material is deposited all over the wafer surface. The etched area is filled by a doped Polysilicon layer of thickness d (d > p/2 in order to fill in the structure). The etched area becomes a resistive area with a depth equal to the height of the 3D patterns, higher than the thickness of the deposited Polysilicon layer (h > d).

When only the doped Polysilicon resistor is needed, technical stages b, d, e and f are not necessary.

When only the resistor diffused into the substrate is needed, the filling material may be other than doped Polysilicon.

In order to get even smaller sheet resistances, it is possible to connect in parallel the doped Polysilicon resistor and the doped silicon resistor. This is can be achieved by not deposing the dielectric layer (technical stage f) or with external wiring connections.

This method can be detected by realizing a cross-section followed by an observation with electronic microscopy.

In a third aspect the present invention relates to a device, such as an IC or SiP comprising a semiconductor device according to the invention.

The present invention is further elucidated by the following figures and examples, which are not intended to limit the scope of the invention. The person skilled in the art will understand that various embodiments may be combined.

BRIEF DESCRIPTION OF THE DRAWINGS

Fig. 1. Formation of a resistor according to the invention.

Fig. 2. Formation of a resistor according to the invention.

Fig. 3. Formation of a resistor according to the invention.

Fig. 4a,b. SEM picture of the present 3D low value resistors.

Fig. 5a. Top view of an embodiment of the present 3D low value resistors.

Figure 5b. Side view of an embodiment of the present 3D low value resistors.

DETAILED DESCRIPTION OF THE DRAWINGS

Fig. 1. Formation of a resistor according to the invention. First a 3D pattern 120 having a pitch 130 is formed in a substrate 150, having a depth 140, wherein the substrate is partly covered with an insulating material 110, and wherein the substrate is partly doped 100.

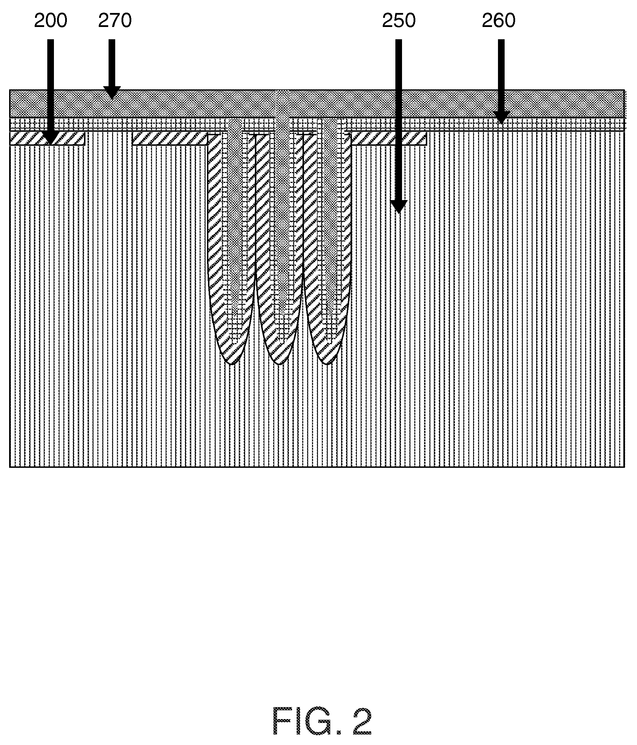

Fig. 2. Formation of a resistor according to the invention. The resistor of figure 1 is partly etched, then covered with an insulating layer 260, and filled with a conducting material 270.

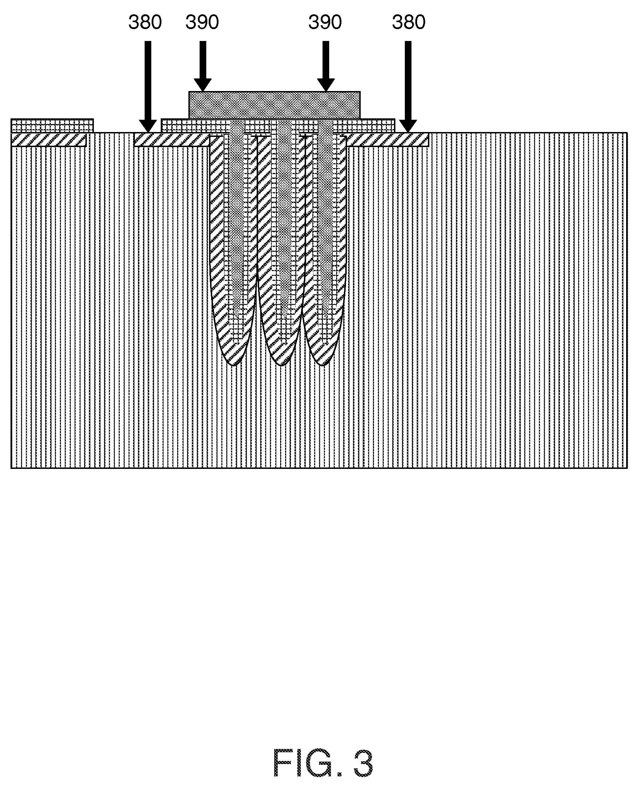

Fig. 3. Formation of a resistor according to the invention. The resistor of figure 2 is partly etched, whereafter electrically conducting contacts (390) are attached to the resistor comprising polysilicon, and electrically conducting contacts (380) are attached to the substrate.

Fig. 4a,b. SEM picture of the present 3D low value resistors. A typical depth of said resistors is in the order of 5-50 $\mu$m. The SEM picture shows a pillar network, before trench filling, wherein the thicknesses are amplified.

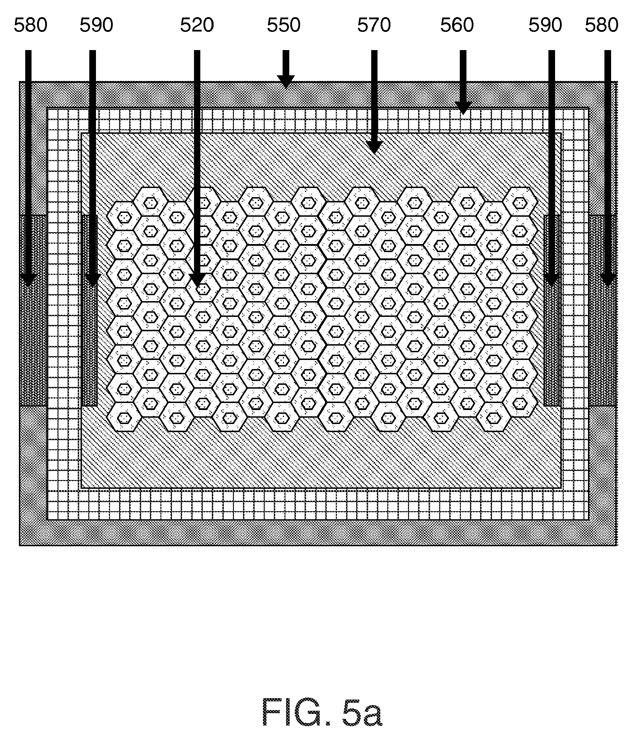

Fig. 5a. Top view of an embodiment of the present 3D low value resistors. Electrodes 1 and 2 correspond to the electrically conducting contacts (590) to the polysilicon resistor. Electrodes 3 and 4 correspond to the electrically conducting contacts (580) to the doped silicon resistor,. Further visible are the filling material (570) (doped polysilicon in this example), the insulating material (560), the 3D pattern (520) that is etched and then filled, and the doped silicon (550). Clearly details are not to scale.

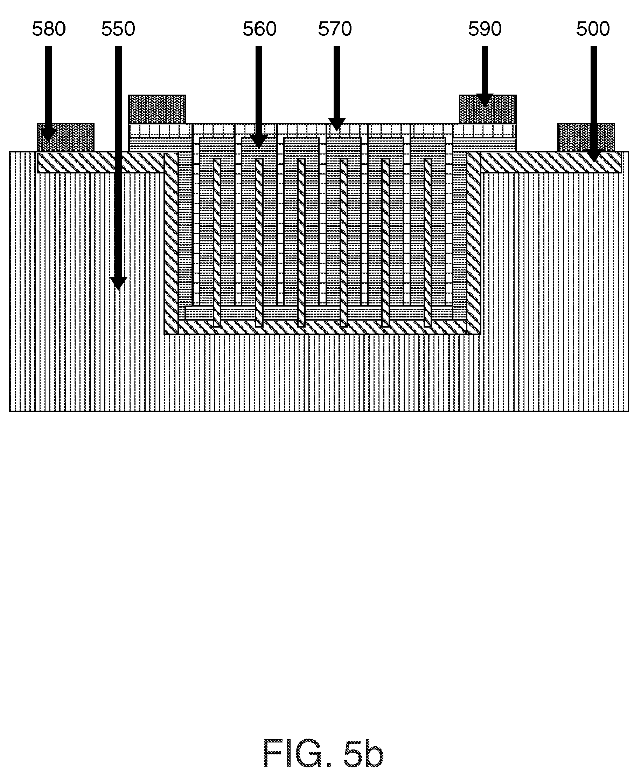

Fig. 5b. Side view of an embodiment of the present 3D low value resistors.

Electrodes 1 and 2 correspond to the electrically conducting contacts (390) to the polysilicon resistor. Electrodes 3 and 4 correspond to the electrically conducting contacts (380) to the doped silicon resistor. Further visible are the filling material (570) (doped polysilicon in this example), the insulating material (560), and the doped silicon (500). Clearly details are not to scale.

Claims

1. Semiconductor device comprising a silicon substrate (150), at least one 3D low value resistor having a resistance of smaller than 1 $\Omega/\square$ , wherein the resistor is present within the substrate by a 3D pattern consisting out of a multiplicity of repeating structures having edges, having a depth (140) in the substrate of more than 5 $\mu$m, and having a pitch $p$ (130), wherein the edges (100) of the 3D pattern are N- or P-type doped, having an insulating material (260) on the edges of one or more materials selected from the group consisting of oxide, silicon nitride, undoped polysilicon, or other oxides such as $Ta_2O_5$, $HfO_2$, $Al_2O_3$, wherein the 3D pattern is further filled with a layer (270) having a thickness d of one or more materials selected from the group consisting of doped polysilicon, and conducting material such as metal or alloy, such as TiN, TiW, TiCu, which layer edges are delimited by photolithography, further comprising first electrically conducting contacts (390), and second electrically conducting contacts (380), wherein:

the structure of the 3D pattern is chosen from the group comprising holes, trenches, pillars, tripods, walls, cavities and combinations thereof, the layer (270) filling the 3D pattern forms a first resistor attached to the first electrically conducting contacts, the doped silicon edges form a second resistor layer attached to the second electrically conducting contacts (380), the first resistor being connected in parallel to the second resistor, and the pitch $p$ of the 3D pattern is from 0.2 $\mu$m to less than 5 $\mu$m.

2. Semiconductor device according to claim 1, wherein the resistivity of the resistor is smaller than 1 $\Omega/\square$, preferably smaller than 0.5 $\Omega/\square$, more preferably smaller than 0.3 $\Omega/\square$, even more preferably smaller than 0.1 $\Omega/\square$, most preferably smaller than 0.05 $\Omega/\square$, such as smaller than 0.001 $\Omega/\square$.

3. Semiconductor device according to claim 1 or 2, wherein the pitch $p$ is from 0.4 $\mu$m to 3 $\mu$m, preferably from 0.6 $\mu$m to 2 $\mu$m, such as 1 $\mu$m.

4. Semiconductor device according to any of claims 1-3, wherein the thickness *d* of the layer (270) is larger than *p*/2, preferably larger than 0.75 *p,* more preferably larger than *p*, such as *2p.*

5. Semiconductor device according to any of claims 1-4, wherein the depth of the 3D pattern is larger than 20 $\mu$m, preferably larger than 50 $\mu$m.

6. Semiconductor device according to any of claims 1-5, wherein the polysilicon is P- or N-type doped, and the substrate is N- or P-type doped, respectively.

7. Semiconductor device according to any of claims 1-6, wherein the doped polysilicon resistor is connected in parallel to the doped silicon resistor.

8. Method for manufacturing a semiconductor device according to any of claims 1-7, comprising the steps of :

 a) providing a silicon substrate,
 b) etching a 3D pattern whose structure is chosen from the group comprising holes, trenches, pillars, tripods, walls, cavities and combinations thereof, with a depth (140) and a pitch *p* (130), preferably by plasma etching or wet etching, for instance using a gas such as $SF_6/O_2$, $NF_3$, or a liquid comprising KOH, HF, or TMAH, wherein the depth of the 3D pattern is larger than 5 $\mu$m, and the pitch *p* is from 0.2 $\mu$m to less than 5 $\mu$m,
 c) doping the substrate and 3D pattern with a concentration of $10^{15}$ - $10^{20}$ at/cm$^3$, wherein the doping is delimited by the mask, optionally in the presence of oxygen,
 d) forming a mask of an insulating material having a thickness of 0.1 $\mu$m to 10 $\mu$m that does not oxidizes in the presence of oxygen, and forming a pattern on said mask.
 e) filling the 3D pattern with a layer (270) having a thickness d of one or more materials selected from the group consisting of doped polysilicon, and conducting material such as metal or alloy, which layer edges are delimited by photolithography, thereby forming resistor which is connected in parallel with a resistor formed by the doped silicon, and
 f) realizing electrodes in order to electrically contact the resistors.

9. Method for manufacturing a semiconductor device according to claim 8, further comprising, between the steps d) and e):

 d1) dissolving the oxide layer in an adapted solution, such as by buffered oxide etch or HF.

10. Method for manufacturing a semiconductor device according to any one of claims 8 or 9, further comprising, between the steps a) and b):

 a1) depositing or growing one or several layers of an insulating material all over the surface of the substrate, which one or several layers have a thickness of 0.01 $\mu$m to 2 $\mu$m.

11. Device, such as an Integrated Circuit, IC, or a System-in-Package, SiP, comprising a semiconductor device according to any one of claims 1-7.

**Patentansprüche**

1. Halbleitervorrichtung, umfassend ein Siliciumsubstrat (150), wenigstens einen niederwertigen 3D-Widerstand mit einem Widerstandswert von weniger als 1 $\Omega/\square$, wobei der Widerstand in dem Substrat in Form eines 3D-Musters vorhanden ist, das aus einer Vielzahl von sich wiederholenden Strukturen mit Rändern gebildet ist, das eine Tiefe (140) von mehr als 5 $\mu$m in dem Substrat aufweist und das einen Mittenabstand *p* (130) aufweist, wobei die Ränder (100) des 3D-Musters N- oder P-dotiert sind, wobei ein Isoliermaterial (260) an den Rändern von einem oder mehreren Materialien vorgesehen ist, die aus der Gruppe gewählt sind, die aus Oxid, Siliciumnitrid, undotiertem Polysilicium oder anderen Oxiden wie $Ta_2O_5$, $HfO_2$, $Al_2O_3$ gebildet ist, wobei das 3D-Muster darüber hinaus mit einer eine Dicke d aufweisenden Schicht (270) aus einem oder mehreren Materialien gefüllt ist, die aus der Gruppe gewählt sind, die aus dotiertem Polysilicium und einem leitenden Material wie einem Metall oder einer Legierung, wie z.B. TiN, TiW, TiCu, gebildet ist, wobei die Ränder der Schicht durch Photolithographie begrenzt werden, ferner umfassend erste elektrisch leitende Kontakte (390) und zweite elektrisch leitende Kontakte (380),
wobei:

 die Struktur des 3D-Musters aus der Gruppe gewählt ist, die Löcher, Gräben, Säulen, Tripods, Wände, Hohlräume und Kombinationen davon umfasst,
 die Schicht (270), die das 3D-Muster füllt, einen ersten Widerstand bildet, der mit den ersten elektrisch leitenden Kontakten verbunden ist,
 die Ränder aus dotiertem Silicium eine zweite Widerstandsschicht bilden, die mit den zweiten elektrisch leitenden Kontakten (380) verbunden ist, wobei der erste Widerstand parallel mit dem zweiten Widerstand geschaltet ist, und
 der Mittenabstand *p* des 3D-Musters von 0,2 $\mu$m bis weniger als 5 $\mu$m beträgt.

2. Halbleitervorrichtung nach Anspruch 1, wobei der spezifische Widerstand des Widerstands kleiner als 1 Ω/□, vorzugsweise kleiner als 0,5 Ω/□, stärker bevorzugt kleiner als 0,3 Ω/□, noch stärker bevorzugt kleiner als 0,1 Ω/□ und am stärksten bevorzugt kleiner als 0,05 Ω/□, wie z.B. kleiner als 0,001 Ω/□, ist.

3. Halbleitervorrichtung nach Anspruch 1 oder 2, wobei der Mittenabstand $p$ von 0,4 μm bis 3 μm, vorzugsweise von 0,6 μm bis 2 μm, wie z.B. 1 μm, beträgt.

4. Halbleitervorrichtung nach einem der Ansprüche 1 bis 3, wobei die Dicke d der Schicht (270) größer als $p/2$, vorzugsweise größer als 0,75 $p$, stärker bevorzugt größer als $p$, wie z.B. 2$p$, ist.

5. Halbleitervorrichtung nach einem der Ansprüche 1 bis 4, wobei die Tiefe des 3D-Musters größer als 20 μm, vorzugsweise größer als 50 μm ist.

6. Halbleitervorrichtung nach einem der Ansprüche 1 bis 5, wobei das Polysilicium P- oder N-dotiert ist und das Substrat N- oder P-dotiert ist.

7. Halbleitervorrichtung nach einem der Ansprüche 1 bis 6, wobei der Widerstand aus dotiertem Polysilicium parallel mit dem Widerstand aus dotiertem Silicium geschaltet ist.

8. Verfahren zur Herstellung einer Halbleitervorrichtung nach einem der Ansprüche 1 bis 7, umfassend die folgenden Schritte:

   a) Bereitstellen eines Siliciumsubstrats,
   b) Ätzen eines 3D-Musters, dessen Struktur aus der Gruppe gewählt ist, die Löcher, Gräben, Säulen, Tripods, Wände, Hohlräume und Kombinationen davon umfasst, mit einer Tiefe (140) und einem Mittenabstand $p$ (130), vorzugsweise durch Plasmaätzen oder Nassätzen, wobei zum Beispiel ein Gas wie $SF_6/O_2$, $NF_3$ oder eine Flüssigkeit verwendet wird, die KOH, HF oder TMAH umfasst, wobei die Tiefe des 3D-Musters größer als 5 μm ist und der Mittenabstand $p$ von 0,2 μm bis weniger als 5 μm beträgt,
   c) Dotieren des Substrats und des 3D-Musters mit einer Konzentration von $10^{15}$ - $10^{20}$ At./cm$^3$, wobei die Dotierung durch die Maske, gegebenenfalls in Gegenwart von Sauerstoff, begrenzt wird,
   d) Bilden einer Maske aus einem Isoliermaterial mit einer Dicke von 0,1 μm bis 10 μm, das in Gegenwart von Sauerstoff nicht oxidiert, und Bilden eines Musters auf der Maske,
   e) Füllen des 3D-Musters mit einer eine Dicke d aufweisenden Schicht (270) aus einem oder mehreren Materialien, die aus der Gruppe gewählt sind, die aus dotiertem Polysilicium und einem leitenden Material wie einem Metall oder einer Legierung gebildet ist, wobei die Ränder der Schicht durch Photolithographie begrenzt werden, wodurch ein Widerstand gebildet wird, der parallel mit einem Widerstand geschaltet ist, der durch das dotierte Silicium gebildet ist, und
f) Bilden von Elektroden, um die Widerstände elektrisch zu verbinden.

9. Verfahren zur Herstellung einer Halbleitervorrichtung nach Anspruch 8, das zwischen den Schritten d) und e) ferner den folgenden Schritt umfasst:

   d1) Lösen der Oxidschicht in einer geeigneten Lösung, z.B. durch ein gepuffertes Oxid-Ätzmittel oder HF.

10. Verfahren zur Herstellung einer Halbleitervorrichtung nach einem der Ansprüche 8 oder 9, das zwischen den Schritten a) und b) ferner den folgenden Schritt umfasst:

   a1) Ablagern oder Züchten von einer oder mehreren Schichten eines Isoliermaterials auf der gesamten Oberfläche des Substrats, wobei die eine oder die mehreren Schichten eine Dicke von 0,01 μm bis 2 μm aufweisen.

11. Vorrichtung wie eine integrierte Schaltung IC oder ein System-in-Package SiP, umfassend eine Halbleitervorrichtung nach einem der Ansprüche 1 bis 7.

**Revendications**

1. Dispositif semi-conducteur comprenant un substrat de silicium (150), au moins une résistance 3D de faible valeur ayant une valeur de résistance inférieure à 1 Ω/□, dans lequel la résistance est présente dans le substrat par un motif 3D consistant en une multiplicité de structures qui se répètent, ayant des bords, ayant une profondeur (140) dans le substrat supérieure à 5 μm, et ayant un pas $p$ (130), dans lequel les bords (100) du motif 3D sont dopés de type N ou P, ayant un matériau isolant (260) sur les bords d'un ou plusieurs matériaux choisis dans le groupe constitué d'oxyde, de nitrure de silicium, de silicium polycristallin non dopé, ou d'autres oxydes tels que $Ta_2O_5$, $HfO_2$, $Al_2O3$, dans lequel le motif 3D est en outre rempli d'une couche (270) ayant une épaisseur d d'un ou plusieurs matériaux choisis dans le groupe constitué de silicium polycristallin dopé et d'un matériau conducteur tel qu'un métal ou un alliage, tel que TiN, TiW, TiCu, les bords de la couche étant délimités par photolithographie, comprenant en outre des premiers contacts électriquement conducteurs (390) et des deuxièmes contacts électriquement conducteurs (380),
dans lequel :

la structure du motif 3D est choisie dans le groupe comprenant des trous, des tranchées, des piliers, des tripodes, des murs, des cavités et des combinaisons de ceux-ci,

la couche (270) remplissant le motif 3D forme une première résistance fixée aux premiers contacts électriquement conducteurs,

les bords de silicium dopé forment une deuxième couche de résistance fixée aux deuxièmes contacts électriquement conducteurs (380), la première résistance étant connectée en parallèle par rapport à la deuxième résistance, et

le pas p du motif 3D est compris entre 0,2 $\mu$m et moins de 5 $\mu$m.

2. Dispositif semi-conducteur selon la revendication 1, dans lequel la résistivité de la résistance est inférieure à 1 $\Omega/\square$, de préférence inférieure à 0,5 $\Omega/\square$, davantage de préférence inférieure à 0,3 $\Omega/\square$, encore davantage de préférence inférieure à 0,1 $\Omega/\square$, vraiment de préférence inférieure à 0,05 $\Omega/\square$, et par exemple inférieure à 0,001 $\Omega/\square$.

3. Dispositif semi-conducteur selon la revendication 1 ou 2, dans lequel le pas p est compris entre 0,4 $\mu$m et 3 $\mu$m, de préférence entre 0,6 $\mu$m et 2 $\mu$m, et par exemple 1 $\mu$m.

4. Dispositif semi-conducteur selon l'une quelconque des revendications 1 à 3, dans lequel l'épaisseur d de la couche (270) est supérieure à $p/2$, de préférence supérieure à 0,75 $p$, davantage de préférence supérieure à p, et par exemple 2$p$.

5. Dispositif semi-conducteur selon l'une quelconque des revendications 1 à 4, dans lequel la profondeur du motif 3D est supérieure à 20 $\mu$m, de préférence supérieure à 50 $\mu$m.

6. Dispositif semi-conducteur selon l'une quelconque des revendications 1 à 5, dans lequel le silicium polycristallin est dopé de type P ou de type N, et le substrat est dopé de type N ou de type P, respectivement.

7. Dispositif semi-conducteur selon l'une quelconque des revendications 1 à 6, dans lequel la résistance de silicium polycristallin dopé est connectée en parallèle de la résistance de silicium dopé.

8. Procédé de fabrication d'un dispositif semi-conducteur selon l'une quelconque des revendications 1 à 7, comprenant les étapes qui consistent à :

a) fournir un substrat de silicium,
b) graver un motif 3D dont la structure est choisie dans le groupe comprenant des trous, des tranchées, des piliers, des tripodes, des murs, des cavités et des combinaisons de ceux-ci, avec une profondeur (140) et un pas p (130), de préférence par gravure au plasma ou par gravure humide, par exemple en utilisant un gaz tel que $SF_6/O_2$, $NF_3$, ou un liquide comprenant KOH, HF, ou TMAH, l'épaisseur du motif 3D étant supérieure à 5 $\mu$m, et le pas p étant compris entre 0,2 $\mu$m et moins de 5 $\mu$m,
c) doper le substrat et le motif 3D avec une concentration de $10^{15}$ à $10^{20}$ at/cm$^3$, le dopage étant délimité par le masque, éventuellement en présence d'oxygène,
d) former un masque d'un matériau isolant ayant une épaisseur comprise entre 0,1 $\mu$m et 10 $\mu$m qui ne s'oxyde pas en présence d'oxygène, et former un motif sur ledit masque,
e) remplir le motif 3D avec une couche (270) ayant une épaisseur d d'un ou plusieurs matériaux choisis dans le groupe constitué de silicium polycristallin dopé, et d'un matériau conducteur tel qu'un métal ou un alliage, les bords de la couche étant délimités par photolithographie, et formant ainsi une résistance qui est connectée en parallèle d'une résistance formée par le silicium dopé, et
f) réaliser des électrodes afin de venir en contact électrique avec les résistances.

9. Procédé de fabrication d'un dispositif semi-conducteur selon la revendication 8, consistant en outre, entre les étapes d) et e), à :

d1) dissoudre la couche d'oxyde dans une solution appropriée, par exemple par oxyde gravant tamponné ou par HF.

10. Procédé de fabrication d'un dispositif semi-conducteur selon l'une quelconque des revendications 8 ou 9, consistant en outre, entre les étapes a) et b), à :

a1) déposer ou faire croître une ou plusieurs couches d'un matériau isolant sur toute la surface du substrat, la ou les couches ayant une épaisseur comprise entre 0,01 $\mu$m et 2 $\mu$m.

11. Dispositif, tel qu'un Circuit Intégré, IC, ou un Système en Boîtier, SiP, comprenant un dispositif semi-conducteur selon l'une quelconque des revendications 1 à 7.

100    110         120    100         150         110

130

140

FIG. 1

FIG. 2

380  390      390    380

FIG. 3

FIG. 4a

FIG. 4b

580    590        520       550       570       560       590   580

FIG. 5a

580    550         560    570         590    500

FIG. 5b

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005093097 A1
- WO 2007066037 A1
- WO 2007066037 A
- US 2005263850 A1
- US 2005263850 A
- JP 02148760 A